# EUROPÄISCHE PATENTANMELDUNG

(11) **EP 1 156 711 A1**
(43) Veröffentlichungstag der Anmeldung: **21.11.2001**
(21) Anmeldenummer: 01102293.6
(22) Anmeldetag: 01.02.2001
(51) Int. Cl.: H05K 9/00

(54) **Verguss- oder Einbettmasse mit elektromagnetischen Abschirmeigenschaften zur Herstellung elektronischer Bauteile**

(30) Priorität: 19.05.2000 DE 10024439
(71) Anmelder: Koppe, Franz, D-92676 Eschenbach Oberpfalz (DE)
(72) Erfinder: Koppe, Franz, D-92676 Eschenbach Oberpfalz (DE)
(74) Vertreter: Dahlmann, Gerhard, Dipl.-Ing.

(57) **Zusammenfassung**

Die Erfindung betrifft eine Verguss- oder Einbettmasse für elektronische Bauelemente zur Abschirmung von elektromagnetischer Strahlung. Die Vergussmasse besteht aus einer polymerem Matrix, die 5 bis 95 Gew.-% elektrisch nicht leitende, magnetische Partikel mit einer mittleren Partikelgröße im Bereich von 1 bis 250 µm enthält.

## Beschreibung

Die Erfindung bezieht sich auf eine Verguss- oder Einbettmasse mit elektromagnetischen Abschirmeigenschaften zur Herstellung elektronischer Bauteile.

### Stand der Technik

Elektronische Bauelemente, wie zum Beispiel integrierte Schaltkreise (Ics), Transistoren und Sensoren verschiedenster Art werden in miniaturisierter Bauform als Chips hergestellt und zum Zweck ihrer besseren Handhabbarkeit und dem Schutz vor Verschmutzungen und aggressiven Atmosphären mit einem Gehäuse versehen, in das der Chip eingebettet und mit einem Polymerharz vergossen wird. Diese Verguss- oder Einbettmaterialien besitzen eine Reihe von typischen Eigenschaften, wie zum Beispiel eine geringe Schrumpfung beim Aushärten, eine gute Wärmeleitfähigkeit, eine hohe elektrische Isolation und gegebenenfalls eine geringe Dielektrizitätskonstante. Weiterhin werden spezielle Anforderungen an das Brand- und Schmelzverhalten der Vergussmassen gestellt. Zur Vermeidung von Störungen aufgrund von elektromagnetischen Feldern werden Bauteile, die sehr empfindlich auf solche Felder reagieren bzw. die selbst elektromagnetische Strahlung aussenden, bei ihrer Anordnung auf Platinen räumlich getrennt oder durch den Einsatz zusätzlicher Maßnahmen wie Abschirmbleche entstört. Der Trend zur Miniaturisierung schränkt diese Möglichkeiten aber immer mehr ein. Weiterhin steigen die Anforderungen an die elektromagnetische Verträglichkeit von elektrischen oder elektronischen Bauelementen beziehungsweise Geräten.

Aus dem Dokument US 5,789,064 ist ein elektromagnetische Strahlung absorbierendes Material bekannt, welches aus einem elektrisch nicht leitenden Körper insbesondere einer Polymermatrix besteht, in der feine Metallpartikel dispergiert sind. Dieses elektromagnetische Strahlung absorbierende Medium wird für die Auskleidung von reflexionsarmen Räumen, wie sie zur Messung von Störstrahlungen und der Störstrahlsicherheit von Geräten oder Fahrzeugen eingesetzt werden, verwendet. Aufgrund der Leitfähigkeit der metallischen Partikel kann die bekannte, elektromagnetische Strahlung absorbierende Masse nicht direkt zum Vergießen elektronischer Schaltungen eingesetzt werden.

### Darstellung der Erfindung

Der Erfindung liegt die Aufgabe zugrunde, eine Verguss- oder Einbettmasse mit elektromagnetischen Abschirmeigenschaften zur Herstellung elektronischer Bauteile anzubieten.

Erfindungsgemäß wird die Aufgabe durch eine Verguss- oder Einbettmasse für elektronische Bauelemente zur Abschirmung von elektromagnetischer Strahlung gelöst, die aus einer polymeren Matrix mit einem Gehalt von 30 bis 95 Gew.-% elektrisch nicht leitenden, magnetischen Partikeln mit einer mittleren Partikelgröße im Bereich von 1 bis 250 µm besteht. Eine solche nicht leitende und elektrisch nicht leitfähige Partikel enthaltende Verguss- oder Einbettmasse reduziert die Aussendung von elektromagnetischen Störfeldern aus integrierten Schaltkreisen beziehungsweise erhöht die Funktionssicherheit solcher Bauelemente gegenüber den auf sie einwirkenden elektromagnetischen Störfeldern. Die Erfindung gestattet somit, den zunehmend verschärften gesetzlichen Bestimmungen im Hinblick auf die elektromagnetische Verträglichkeit von elektronischen und hochfrequenztechnischen Rechnung zu tragen.

Vorzugsweise enthält die Vergussmasse weich magnetische Partikel. Diese Partikel haben sich als besonders effektiv erwiesen.

Besonders bevorzugt ist eine Vergussmasse, die Ferrit-Partikel enthält. Insbesondere hinsichtlich ihres Preises und der magnetischen Eigenschaften haben sich Ferrit-Partikel als sehr günstig erwiesen.

Vorzugsweise besteht die Polymermatrix der erfindungsgemäßen Verguss- oder Einbettmasse aus einer Epoxidharz- oder Polyesterharzmasse, einem Polyurethan oder einem Silikonkautschuk. Solche Polymermassen haben sich als Verguss- oder Einbettmaterial bewährt und erfüllen die an sie gestellten Eigenschaften. Ihre rheologischen Eigenschaften werden durch den Zusatz der elektrisch nicht leitenden, magnetischen Partikel nicht signifikant verändert, sodass sie in den vorhandenen Produktionseinrichtungen und -verfahren eingesetzt werden können.

Die Erfindung betrifft weiterhin ein Verfahren zur Verwendung der Vergussmasse, wobei diese direkt auf die elektrische und/oder elektronische Baugruppe aufgebracht wird. Eine elektrisch isolierende Zwischenschicht ist dabei nicht notwendig. Vorzugsweise wird die erfindungsgemäße Vergussmasse auf elektrische und/oder elektronische Bauteile aufgebracht. Insbesondere bei Transformatoren, Übertragern und Spulen lässt sich dadurch das elektromagnetische Streufeld und damit seine Streufeldverluste verringern. Besonders bevorzugt ist die Verwendung der erfindungsgemäßen Vergussmasse für die Einbettung von elektrischen und/oder elektronischen Sensoren.

Vorzugsweise wird die Vergussmasse durch Aufstreiche, Aufsprühen, Vergießen oder als Tauchlösung auf die elektrischen und/oder elektronischen Bauteile beziehungsweise Baugruppen aufgebracht. Damit sind sehr rationelle Fertigungsverfahren zugänglich.

Die erfindungsgemäße Vergussmasse wird vorzugsweise in Schichtdicken von 0,1 bis 50 mm eingesetzt. Damit lassen sich im Frequenzbereich von 1000 bis 5000 kHz Abschirmfaktoren < 75% erzielen.

### Beispiel 1

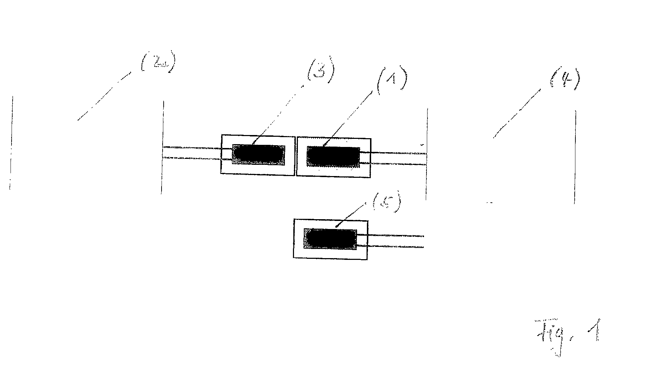

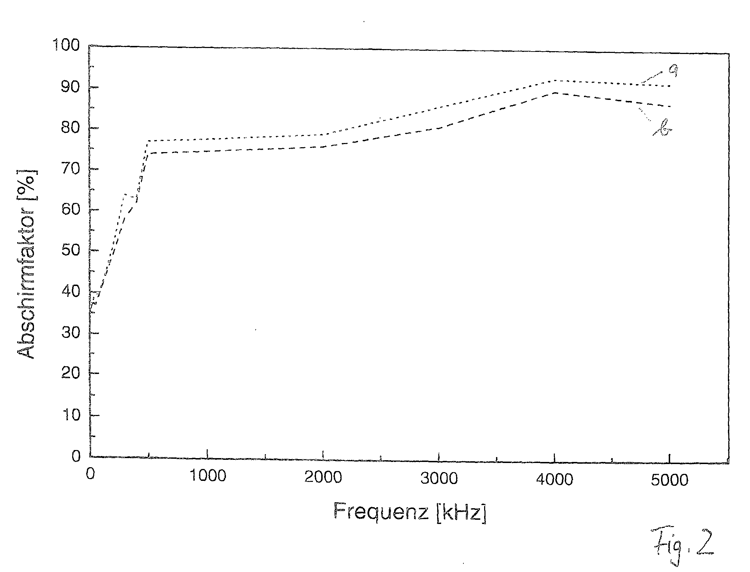

In einem zylindrischen Glasgefäß wurde eine Spule eingebracht und mit einem Zwei-Komponenten Polyurethanharz so vergossen, daß eine ca. 5 mm dicke Vergußmassenschicht die Spule allseitig umgibt. Die Polyurethanharzmasse enthielt 36 Gew. % Ferritanteile im mittleren Partikelgrößenbereich von 1 bis 50 µm. Nach der Aushärtung der Polyurethanharzmasse wurde die so elektromagnetisch abgeschirmte Spule in dem in Figur 1 dargestellten Versuchsaufbau als Empfangsspule (ESM) eingesetzt. Der Meßaufbau zur Bestimmung des in Abbildung 2 dargestellten elektromagnetischen Abschirmeffektes sah dabei so aus, daß an einen Hochfrequenzgenerator (2) eine Sendespule (3) angeschlossen wurde. Die Sendespule wurde in einen zur Empfangsspule (1) gleich großen zylindrischen Glasgefäß in eine bekannte Vergußmasse so eingebettet, daß sie allseitig von einer ca. 5 mm dicken Vergußmasseschicht umschlossen ist. Sende- (3) und Empfangsspule (1) wurden Boden an Boden angeordnet und die Empfangsspule (1) mit einem Oszilloskop (4) verbunden. Als Referenz wurde eine, der Sendespule (3) entsprechende Empfangsspule (5) eingesetzt. Die elektrischen und mechanischen Eigenschaften der Sende- (3), Empfangs- (1) und Referenzspule (5) wurden im Rahmen ihrer Fertigungsgenauigkeit identisch gewählt.

### Beispiel 2

Analog Beispiel 1 wurde eine Empfangsspule (1) hergestellt mit dem Unterschied, daß Ferrit-Teilchen mit einem mittleren Partikelgröße im Bereich von 150 bis 250 um eingesetzt wurden.

Figur 2 zeigt den Vergleich der erzielten elektromagnetischen Abschirmung, angegeben als prozentualer Abschirmfaktor gegenüber der Referenzspule (5). Die Kurve a wurde dabei mit einer Empfangsspule (1) gemäß Beispiel 1 und die Kurve b wurde mit einer Empfangsspule (1) gemäß Beispiel 2 erhalten.

## Patentansprüche

1. Verguss- oder Einbettmasse für elektronische Bauelemente zur Abschirmung von elektromagnetischer Strahlung bestehend aus einer polymeren Matrix, die 5 bis 95 Gew.-% elektrisch nichtleitende, magnetische Partikel mit einer mittleren Partikelgröße im Bereich von 1 bis 250 µm enthält.

2. Vergussmasse nach Anspruch 1, **dadurch gekennzeichnet, dass** sie weichmagnetische Partikel enthält.

3. Vergussmasse nach einem der Ansprüche 1 oder 2, **dadurch gekennzeichnet, dass** sie Ferrit-Partikel enthält.

4. Vergussmasse nach einem der Ansprüche 1 bis 3, **dadurch gekennzeichnet, dass** die Polymermatrix aus Epoxidharz- oder Polyesterharzmassen, einem Polyurethan oder einem Silikonkautschuk besteht.

5. Verfahren zur Verwendung einer Vergussmasse nach einem der Ansprüche 1 bis 4, **dadurch gekennzeichnet, dass** sie auf elektrische und/oder elektronische Baugruppen aufgebracht wird.

6. Verfahren zur Verwendung einer Vergussmasse nach einem der Ansprüche 1 bis 4, **dadurch gekennzeichnet, dass** sie auf elektrische und/oder elektronische Bauteile aufgebracht wird.

7. Verfahren nach Anspruch 6, **dadurch gekennzeichnet, dass** sie auf elektrische und/oder elektronische Sensoren aufgebracht wird.

8. Verfahren nach einem der Ansprüche 1 bis 7, **dadurch gekennzeichnet, dass** die Vergussmasse durch Aufstreichen, Aufsprühen, Vergießen oder als Tauchlösung aufgebracht wird.

9. Verfahren nach einem der Ansprüche 1 bis 8, **dadurch gekennzeichnet, dass** die Vergussmasse in Schichtdicken von 0,1 bis 50 mm eingesetzt wird.
